# EUROPEAN PATENT APPLICATION

(11) **EP 2 493 273 A1**
(43) Date of publication of application: **29.08.2012**
(21) Application number: 10824714.9
(22) Date of filing: 04.08.2010
(51) Int. Cl.: H05K 1/11, H05K 1/18, H05K 3/40

(54) **DEVICE-MOUNTING STRUCTURE AND DEVICE-MOUNTING METHOD**

(30) Priority: 23.10.2009 JP 2009244395
(71) Applicant: Fujikura, Ltd., Tokyo 135-8512 (JP)
(72) Inventor: YAMAMOTO Satoshi, Sakura-shi Chiba 285-8550 (JP); HIRANO Hiroyuki, Sakura-shi Chiba 285-8550 (JP); SUZUKI Takanao, Sakura-shi Chiba 285-8550 (JP)
(74) Representative: Cabinet Plasseraud
(86) International application number: PCT/JP2010/063184
(87) International publication number: WO 2011/048862

(57) **Abstract**

Provided is a device packaging structure including: an interposer substrate including a substrate, and a plurality of through-hole interconnections formed inside a plurality of through-holes passing through the substrate from a first main surface toward a second main surface, the first main surface being one main surface of the substrate, the second main surface being the other main surface thereof; a first device which includes a plurality of electrodes and is arranged so that these electrodes face the first main surface; and a second device which includes a plurality of electrodes of which an arrangement is different from an arrangement of each of the electrodes of the first device, and is arranged so that these electrodes face the second main surface. Each of the through-hole interconnections includes a first conductive portion, provided at a position corresponding to the electrode of the first device, on the first main surface, and a second conductive portion, provided at a position corresponding to the electrode of the second device, on the second main surface, each electrode of the first device is electrically connected to the first conductive portion, each of the electrodes of the second device is electrically connected to the second conductive portion, and each of the through-hole interconnections includes a linear portion vertically extending from at least one of the first main surface and the second main surface.

## Description

### TECHNICAL FIELD

The present invention relates to a device packaging structure and a device packaging method for packaging devices on both sides of an interposer substrate including through-hole wirings passing through a substrate.
This application claims priority based on Japanese Patent Application No. 2009-244395 filed in the Japanese Patent Office on October 23, 2009, the contents of which are incorporated therein by reference.

### BACKGROUND ART

In the past, methods of providing through-hole interconnections passing through a substrate have been commonly used as a method of electrically connecting devices which are respectively mounted on both sides of the substrate.

In an interposer substrate including through-hole interconnections in the related art which are formed in the direction perpendicular to the main surface of a substrate, when a plurality of substrates are connected, slipping-off of a through-hole interconnections electrode or peeling-off of the interface may occur due to damage caused by the external bonding force.
In order to solve this problem, Patent Document 1 discloses an interposer substrate including through-hole interconnections which are inclined in a direction perpendicular to the main surface of a substrate.

In addition, when the types of devices mounted on both sides of the substrate are different from each other, the arrangements of the electrodes necessary for each device are different from each other.
For this reason, a surface wiring for eliminating the difference may be used.
However, when the surface wiring is provided in the main surface of the substrate, the area occupied by the surface wiring in the main surface increases.
In addition, in order to prevent wirings from being short-circuited to each other or electrical signals flowing through the wirings from interfering with each other, it is necessary to provide a predetermined gap (space) between the wirings.
As a result, there is a problem in that freedom of design in the arrangement of the device on the substrate is small.
In addition, when the wiring length is long, there is also a problem in that signal delay is generated, or high-frequency characteristics are deteriorated.

Further, when each device includes a large number of electrodes in the surface facing the substrate, the surface wiring as mentioned above is not able to cope with the aforementioned problems.
In this case, a multilayer wiring in which each layer is connected through an interlayer via is needed.
For this reason, problems such as an increase in the interconnection length due to the formation of the multilayer wiring and the deterioration of high-frequency characteristics accompanied therewith are generated, and substrate manufacturing processes also become complicated.

### PRIOR ART DOCUMENTS

### PATENT DOCUMENTS

[Patent Document 1] Japanese Patent No. 3896038

### DISCLOSURE OF INVENTION

### PROBLEMS TO BE SOLVED BY INVENTION

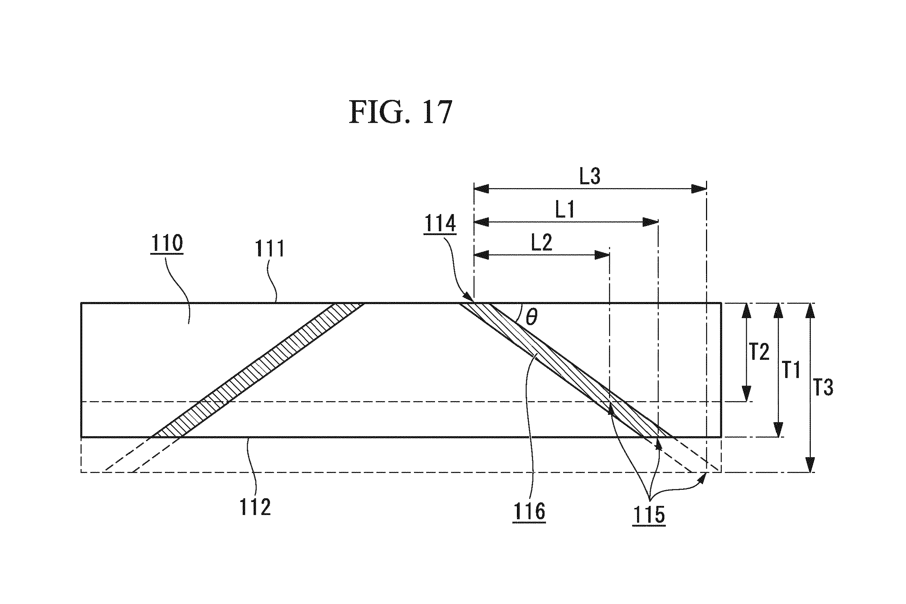

When a device mounted on both main surfaces of an interposer substrate is a device having arrangements of electrodes different from each other, and electrodes are densely arranged, openings, formed in both main surfaces, of the through-hole interconnection placed in the interposer substrate are required to be provided with a high degree of positional accuracy.
However, in the interposer substrate including the through-hole interconnection inclined in the direction perpendicular to the main surface of the substrate, it may be difficult to provide openings with a high degree of positional accuracy.
For example, as shown in FIG 17, when a variation in the original thickness of a substrate used in manufacturing an interposer substrate occurs, or when a variation in the thickness due to processing accuracy in a process of polishing the substrate occurs, the thickness of the interposer substrate is not set to thickness T1 originally designed, but may be set to thickness T2 or thickness T3.
At this time, the length of the through-hole interconnection in the width direction of the substrate is not set to length L1 originally designed, but is set to length L2 or length L3.
In this case, in the main surface 112 shown in FIG 17, the relative positional relationship between a plurality of openings 115 included in a plurality of through-hole interconnections is also different from the correct positional relationship.
As a result, the electrode arrangement of the device to be mounted in the main surface 112 and the arrangement of the opening 115 provided in the main surface 112 connected thereto may be misaligned beyond the allowable range.

The present invention is contrived in view of such circumstances, and an object thereof is to provide a device mounting structure capable of connecting electrodes of a device mounted on both sides of an interposer substrate freely and accurately, without forming a multilayer interconnect structure with respect to the device in which electrodes are arranged with a high density and with a different layout.
In addition, another object of the present invention is to provide a device packaging method capable of performing the connection accurately, freely, and with a high yield rate, when a variation in the original thickness of a substrate used in manufacturing the interposer substrate occurs, or when a variation in the thickness due to processing accuracy in a process of polishing the substrate occurs.

### MEANS FOR SOLVING THE PROBLEMS

In order to solve the above-mentioned problems, the present invention adopts the following configurations.
That is, according to a first aspect of the invention, there is provided a device packaging structure including: an interposer substrate including a substrate, and a plurality of through-hole interconnections formed inside a plurality of through-holes passing through the substrate from a first main surface toward a second main surface, the first main surface being one main surface of the substrate, the second main surface being the other main surface thereof; a first device which includes a plurality of electrodes and is arranged so that these electrodes face the first main surface; and a second device which includes a plurality of electrodes of which an arrangement is different from an arrangement of each of the electrodes of the first device, and is arranged so that these electrodes face the second main surface. Furthermore, each of the through-hole interconnections includes a first conductive portion which is provided at a position corresponding to the electrode of the first device, on the first main surface, and a second conductive portion which is provided at a position corresponding to the electrode of the second device, on the second main surface, each of the electrode of the first device is electrically connected to the first conductive portion, each of the electrodes of the second device is electrically connected to the second conductive portion, and each of the through-hole interconnections includes a linear portion vertically extending from at least one of the first main surface and the second main surface.

A flow channel may be provided inside the substrate.

In addition, according to a second aspect of the invention, there is provided a device packaging method of electrically connecting a first device including a plurality of electrodes to a second device including a plurality of electrodes of which an arrangement is different from an arrangement of each of the electrodes of the first device, through an interposer substrate including a substrate, and a plurality of through-hole interconnections formed inside a plurality of through-holes passing through the substrate from a first main surface which is one main surface of the substrate toward a second main surface which is the other main surface thereof, the method including: step A1 of forming a plurality of modified regions which include one end which is exposed to a position corresponding to each of the electrodes of the first device on the first main surface, and the other end which is exposed to a position corresponding to each of the electrodes of the second device on the second main surface; step A2 of forming the plurality of through-holes in a region in which the plurality of modified regions are formed; step A3 of forming a plurality of through-hole interconnections including a first conductive portion exposed to the first main surface side and a second conductive portion exposed to the second main surface side, by filling or forming a conductor within each of the through-holes; and step A4 of bonding each of the electrodes of the first device to the corresponding first conductive portion by disposing the first device so as to face the first main surface of the substrate, and bonding each of the electrodes of the second device to the corresponding second conductive portion by disposing the second device so as to face the second main surface of the substrate. Furthermore the step A1 includes a step of providing a linear portion vertically extending from at least one of the first main surface and the second main surface, and a step of providing a portion which is connected to the linear portion and extends inclined to both the first main surface and the second main surface.

The device packaging method may further include a step of reducing a thickness of the substrate by polishing a main surface in which the linear portion is provided using physical or chemical means.

The device packaging method may further include step A5 of forming a flow channel inside the substrate.

### EFFECTS OF THE INVENTION

According to the device packaging structure of the present invention, since the electrodes of the device mounted on both sides of the interposer substrate are electrically connected to each other without being through the surface interconnection, it is possible to perform the free connection in a small-sized device in which the electrodes are densely arranged.
In addition, when the densely arranged electrodes of the device mounted on both sides of the interposer substrate are freely connected to each other, a variation in the original thickness of the substrate used in manufacturing the interposer substrate occurs, or a variation in the thickness due to processing accuracy in a process of polishing the substrate occurs, the position of the opening provided in the main surface of the interposer substrate does not fluctuate.
As a result, the connection is performed accurately and reliably.

According to the device packaging method of the present invention, since the electrodes of the device mounted on both sides of the interposer substrate are electrically connected to each other without being through the surface wiring, it is possible to perform the free connection in a small-sized device in which the electrodes are densely arranged.
In addition, when the densely arranged electrodes of the device mounted on both sides of the interposer substrate are freely connected to each other, a variation in the original thickness of the substrate used in manufacturing the interposer substrate occurs, or a variation in the thickness due to processing accuracy in a process of polishing the substrate occurs, the position of the opening provided in the main surface of the interposer substrate does not fluctuate.
As a result, it is possible to perform the connection accurately and with a high yield rate.
In addition, in the device packaging method of the present invention, after steps A1, A2, or A3 mentioned above, the main surface on the side in which the linear portion is provided is grinded using physical or chemical means, and the thickness of the substrate is reduced, thereby allowing the thickness of the manufactured interposer substrate to be appropriately adjusted.
Here, when the grinding is performed after step A1 mentioned above, it is possible to shorten the time of etching or the like in subsequent step A2, and the processing time of forming or filling the conductor in step A3.
Further, it is possible to reduce the amount of the conductor used in step A3.
When the grinding is performed after step A2, it is possible to shorten the processing time of forming or filling the conductor in subsequent step A3.
Further, it is possible to reduce the amount of the conductor used in step A3.
When the grinding is performed after step A3, it is possible to planarize the conductor constituting the through-hole interconnection exposed to the main surface together with the main surface.
In addition, in the device packaging method of the present invention, it is possible to further form a flow channel in the through-hole using step A5.

### BRIEF DESCRIPTION OF THE DRAWINGS

FIG 1A is a plan view illustrating a device packaging structure according to an embodiment of the invention.
FIG 1B is a cross-sectional view taken along the A-A line of FIG 1A.
FIG 2A is a plan view illustrating an interposer substrate used in the device packaging structure shown in FIGS. 1A and 1B.
FIG 2B is a cross-sectional view taken along the B-B line of FIG 2A.
FIG 3 is a perspective view illustrating the interposer substrate shown in FIGS. 2A and 2B.
FIG 4A is a cross-sectional view illustrating an initial step of a process of forming a through-hole and a through-hole interconnection in a substrate.
FIG 4B is a cross-sectional view illustrating a step subsequent to FIG 4A.
FIG 4C is a cross-sectional view illustrating a step subsequent to FIG 4B.
FIG 4D is a cross-sectional view illustrating a step subsequent to FIG 4C.
FIG 5A is a plan view illustrating a device packaging structure according to a first modified example of the embodiment.
FIG 5B is a cross-sectional view taken along the A-A line of FIG 5A.
FIG 6A is a plan view illustrating a device packaging structure according to a second modified example of the embodiment.
FIG 6B is a cross-sectional view taken along the C-C line of FIG 6A.
FIG 7A is a plan view illustrating a device packaging structure according to a third modified example of the embodiment.
FIG 7B is a cross-sectional view taken along the D-D line of FIG 7A.
FIG 8A is a plan view illustrating a device packaging structure according to a fourth modified example of the embodiment.
FIG 8B is a cross-sectional view taken along the E-E line of FIG 8A.
FIG 9 is a partial plan view schematically illustrating a connection relationship of electrodes in a lower-left quarter portion of the device packaging structure shown in FIGS. 8A and 8B.
FIG 10 is a cross-sectional view illustrating an example in which bumps are provided in the device packaging structure according to the invention.
FIG 11 is a cross-sectional view illustrating an example in which a molding resin layer is provided in the device packaging structure according to the invention.
FIG 12 is a cross-sectional view illustrating an example in which a protective member with a cavity is provided in the device packaging structure according to the invention.
FIG 13A is a plan view illustrating a first example of the interposer substrate having flow channels.
FIG 13B is a cross-sectional view taken along the I-I line of FIG 13A.
FIG 13C is a cross-sectional view taken along the J-J line of FIG 13A.
FIG 14A is a plan view illustrating a second example of the interposer substrate having flow channels.
FIG 14B is a cross-sectional view taken along the K-K line of FIG 14A.
FIG 14C is a cross-sectional view taken along the L-L line of FIG 14A.
FIG 15A is a plan view illustrating a third example of the interposer substrate having flow channels.
FIG 15B is a cross-sectional view taken along the M-M line of FIG 15A.
FIG 15C is a cross-sectional view taken along the N-N line of FIG 15A.
FIG 16A is a cross-sectional view illustrating an initial step of a method of manufacturing an interposer substrate having through-holes used as flow channels.
FIG 16B is a cross-sectional view illustrating a step subsequent to FIG 16A.
FIG 16C is a cross-sectional view illustrating a step subsequent to FIG 16B.
FIG 16D is a cross-sectional view illustrating a step subsequent to FIG 16C.
FIG 16E is a cross-sectional view illustrating a step subsequent to FIG 16D.
FIG 16F is a cross-sectional view illustrating a step subsequent to FIG 16E.
FIG 17 is a cross-sectional view illustrating through-hole interconnections in an interposer substrate in the related art.

### EMBODIMENTS FOR CARRYING OUT THE INVENTION

Hereinafter, a preferred embodiment of the invention will be described with reference to the drawings.

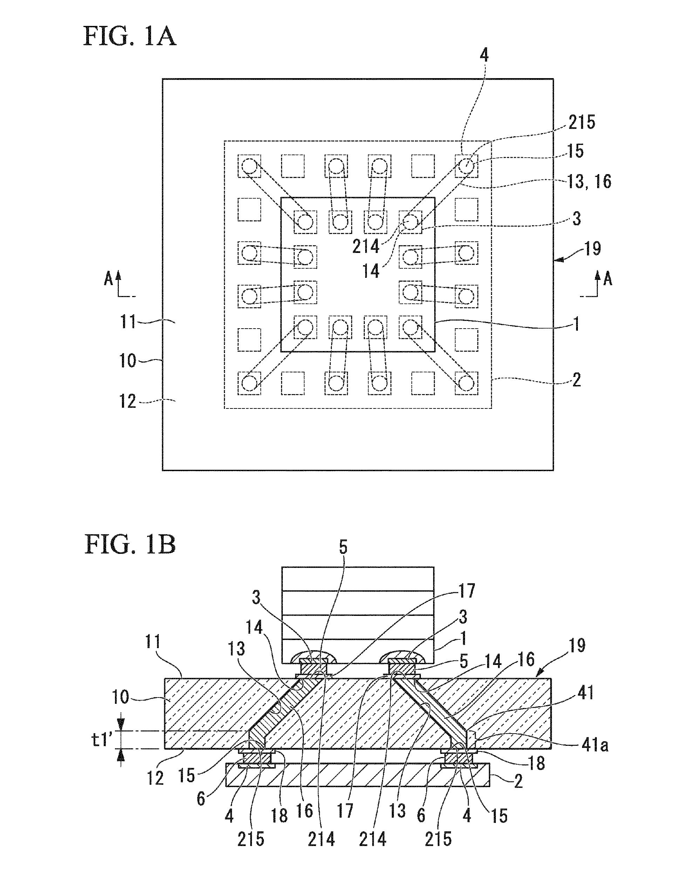

FIGS. 1A to 3 show a device packaging structure according to an embodiment of the invention.
The device packaging structure includes a substrate 10, an interposer substrate 19 having through-hole interconnections 16 formed inside a plurality of through-holes 13 passing through the substrate 10 of one main surface (hereinafter, referred to as the "first main surface") 11 of the substrate 10 toward the other main surface (hereinafter, referred to as the "second main surface") 12 thereof; a first device 1 that has a plurality of electrodes 3 and is arranged so that electrodes 3 face the first main surface 11; and a second device 2 that has a plurality of electrodes 4 of which the arrangement is different from the arrangement of each of the electrodes 3 of the first device 1 and is arranged so that the electrodes 4 face the second main surface. Each of the through-holes 13 includes a first conductive portion 214, provided at a position facing the electrode 3 of the first device 1, on the first main surface 11, and a second conductive portion 215, provided at a position facing of the electrode 4 of the second device 2, on the second main surface 12, each of the electrodes 3 of the first device 1 is electrically connected to the first conductive portion 214, and each of the electrodes 4 of the second device 2 is electrically connected to the second conductive portion 215.

In addition, the through-hole 13 serving as the through-hole interconnection 16 includes a bent portion 41, and is constituted by a linear portion 41 a extending from an opening 15 to the bent portion 41 and a portion extending from the bent portion 41 to an opening 14 and extending inclined to the first main surface 11 and the second main surface 12.
The linear portion 41a extends in the direction perpendicular to the second main surface 12, that is, the thickness direction of the substrate 10.
In addition, the bent portion 41 is located from the second main surface 12 to the depth of t1'.
That is, the length of the linear portion 41 a is t1'.

In the interposer substrate 19, a plurality of electrodes 3 of the first device 1 and a plurality of electrodes 4 of the second device 2 are electrically connected to each other through a plurality of through-hole interconnections 16.
In order to connect the electrodes 3 and 4 to each other through the through-hole interconnections 16 so that the distance therebetween is as short as possible, it is preferable that the depth of t1' is as short as possible.
Further, it is preferable that the portion between the bent portion 41 and the opening 14 (portion extending inclined to the first main surface 11 and the second main surface 12) is linearly formed.
The cross-sectional shape of the bent portion 41 along the thickness direction of the substrate may be a shape which has a corner, and may be a substantially arc-like shape which does not have a corner.

As described above, the length of t1' is preferably as short as possible.
The length of t1' is appropriately designed so that the linear portion 41 a is inevitably provided in consideration of a variation in the original substrate thickness capable of being generated for each lot, or a processing variation in the thickness of the substrate 10 capable of being generated in a process of manufacturing the interposer substrate 19.

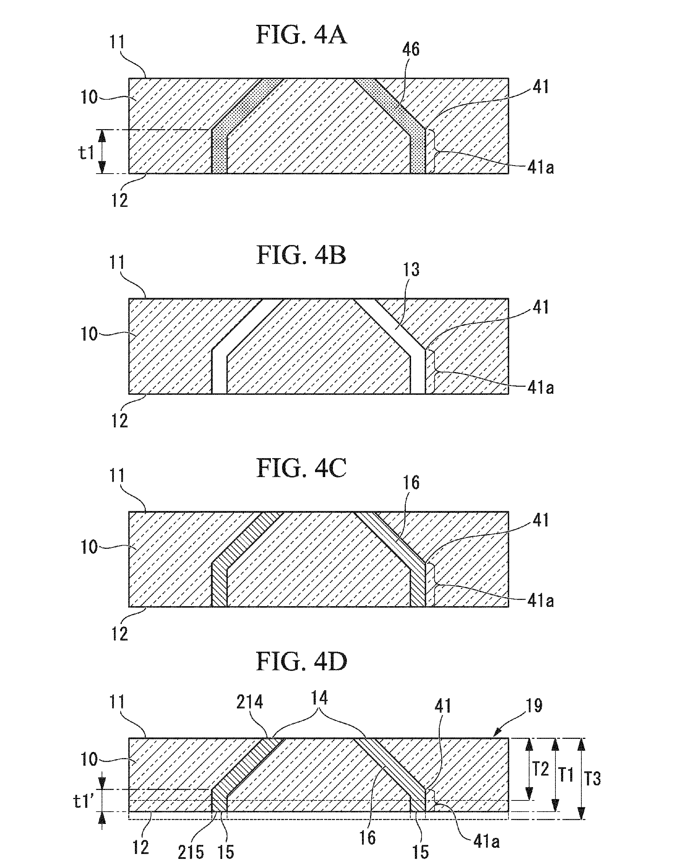

Further, a description will be made with reference to FIGS. 4A to 5B.
FIGS. 4A to 4D show cross-sectional views illustrating an example of a method of forming the through-hole interconnections 16 in the substrate 10.
First, as shown in FIG 4A, a modified region 46 is formed in a region serving as the through-hole 13 afterwards, using a laser technique or the like described later (step A1).
One end of the modified region 46 serves as the opening 14 of the through-hole 13 afterwards.
The other end of the modified region 46 serves as the opening 15 of the through-hole 13 afterwards.
The modified region 46 includes the bent portion 41, and is constituted by the linear portion 41 a extending from the other end thereof to the bent portion 41 and a portion extending from the bent portion 41 to one end thereof and extending inclined to the first main surface 11 and the second main surface 12.
The linear portion 41a extends in the direction perpendicular to the second main surface 12, that is, the thickness direction of the substrate 10.
In addition, the bent portion 41 is located from the second main surface 12 to the depth of t1.
That is, the length of the linear portion 41 a is t1.

Next, the substrate 10 in which the modified region 46 is formed is immersed in an etching solution (chemical), and the modified region 46 is removed from the substrate 10 by etching (wet etching).
As a result, as shown in FIG 4B, the through-hole 13 is formed in the portion in which the modified region 46 exists (step A2).
Subsequently, a conductor is filled or formed in the through-hole 13 by a plating method or the like described later, and as shown in FIG 4C, the through-hole interconnection 16 including a first conductive portion 114 exposed to the first main surface 11 side and a second conductive portion 115 exposed to the second main surface 12 side is formed (step A3).
The substrate 10 is polished from the second main surface 12 side which is the main surface on the side in which the linear portion 41 a is formed, for example, by a mechanical polishing method or the like, and the substrate 10 is formed to a desired thickness (step A5).
At this time, the conductor exposed to the second main surface 12 in the opening 15 is planarized together with the second main surface 12 by polishing.
In addition, the length t1 of the linear portion 41 a is shortened by polishing, and is set to t1'.
As a result, the interposer substrate 19 shown in FIG 4D is obtained.

Here, when the fluctuation in the thickness occurs in the substrate 10, for example, when the original thickness of the substrate 10 is smaller than the assumed thickness, or the polishing of the substrate 10 is more excessively performed than assumed, the thickness of the manufactured interposer substrate 19 is not the assumed thickness T1, but may be set to T2 (see FIG 4D).
Even in this case, since the linear portion 41 exists in the interposer substrate 19, the position of the opening 15 in the second main surface 12 does not fluctuate.
Thus, in step A4 described later, the connection between the electrode 4 and the conduction portion 215 of the second device 2 can be performed accurately, reliably, and with a high yield rate.
In addition, as a separate case where the fluctuation in the thickness occurs in the substrate 10, for example, when the original thickness of the substrate 10 is larger than the assumed thickness, or the polishing of the substrate 10 is performed less than assumed, the thickness of the manufactured interposer substrate 19 is not the assumed thickness T1, but may be set to T3 (see FIG 4D).
Even in this case, since the linear portion 41 exists in the interposer substrate 19, the position of the opening 15 in the second main surface 12 does not fluctuate.
Thus, in step A4 described later, the connection between the electrode 4 and the conduction portion 215 of the second device 2 can be performed with a high accuracy, reliability, and with a high yield rate.

In the above-mentioned example, step A5 of polishing the second main surface 12 of the substrate 10 is performed after step A3 of forming the through-hole interconnection 16, but step A5 may be performed after step A1 of forming the modified region 43, or step A2 of forming the through-hole 13.
In any of these cases, the manufactured interposer substrate 19 can be formed to a desired thickness.
When step A5 is performed after step A3, the conductor exposed to the second main surface 12 in the opening 15 is preferably planarized together with the second main surface 12 by polishing.
In addition, when step A5 is performed after step A1, it is possible to shorten the time of etching or the like in subsequent step A2, and the processing time of forming or filling the conductor in step A3.
Further, it is possible to reduce the amount of the conductor used in step A3.
In addition, when step A5 is performed after step A2, it is possible to shorten the processing time of forming or filling the conductor in subsequent step A3.
Further, it is possible to reduce the amount of the conductor used in step A3.

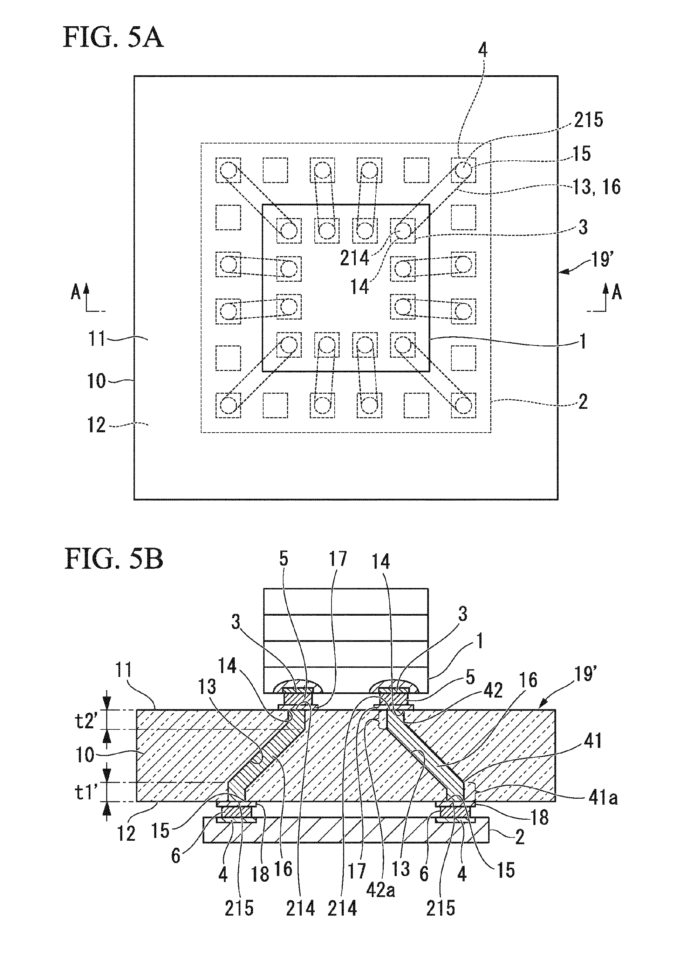

In addition, in the above-mentioned example, although the description is made of a case where the second main surface 12 is polished, a linear portion 42a is provided on the first main surface 11 side (see FIG 5B), and thus the thickness of the substrate 10 may be set to a desired thickness by polishing the first main surface 11.
In this case, the same effect as the case where the second main surface 12 is polished is also obtained.
Additionally, in FIG 5B, the linear portion 42a extends in the direction perpendicular to the first main surface 11, that is, the thickness direction of the substrate 10.
In addition, the bent portion 42 is located from the first main surface 11 to the depth of t2'.
That is, the length of the linear portion 42a is t2'.

Even when an unintended fluctuation in the thickness of the substrate 10 mentioned above occurs, the size of the fluctuation generally falls within a range of 1 µm to 50 µm.
Thus, the length of the linear portion 41 a or 42a included in the modified region 43 formed in step A1 is preferably longer than the possible size of the fluctuation.
In addition, when the through-hole interconnection 16 becomes longer, the signal delay between the devices or the deterioration of high-frequency characteristics may be generated, and thus the lengths t1' and t2' are more preferably shorter.

The lengths t1' and t2'in the singe through-hole interconnection 16 may be the same as or different from each other.
In addition, the lengths t1' and the lengths t2' of the individual through-hole interconnection of a plurality of through-hole interconnections 16 included in the interposer substrate 19 may be the same as or different from each other.

In the interposer substrate 19 according to the invention manufactured as mentioned above, each of the through-holes 13 constituting a plurality of through-hole interconnections 16 includes the linear portion 41a and/or the linear portion 42a which are vertically opened in line with the same main surface side of at least one of the first main surface 11 and the second main surface 12.
In addition, in the interposer substrate 19 according to the invention, each of the through-holes 13 constituting the plurality of through-hole interconnections 16 preferably includes the linear portion 41a and/or linear portion 42a having the same length which are vertically opened in line with the same main surface side of at least one of the first main surface 11 and the second main surface 12.
In this case, since all the through-holes include the linear portions having the same length on the same main surface side, and thus even when the fluctuation in the thickness of the substrate 10 occurs, the through-hole with a linear portion and the through-hole without a linear portion are not mixed with each other in the interposer substrate 19.
For this reason, the connection is performed accurately and reliably.

In the invention, the electrode arrangement (layout) of the device means a two-dimensional arrangement of the electrode which is connected to the through-hole interconnection within the surface facing the main surface of the interposer substrate of the corresponding device.
That is, the entirety of the device is moved in parallel merely to displace the positions of all the electrodes by the same distance in the same direction, and the electrode arrangement of the device does not change.
When the distance between two corresponding electrodes or the angle between three corresponding electrodes, and the like are different in at least one place between two devices, the arrangements of the electrodes between the two devices are different from each other.
For example, even when the arrangements of the electrodes between the two devices are in a similarity relationship in which only the pitch between the electrodes is different, the arrangements of the electrodes between the two devices are different from each other.
In addition, even though the electrodes of two devices are constituted by a plurality of blocks having exactly the same layout, the arrangements of the electrodes of the two devices are different from each other in the case where the positions of these blocks are different from each other between the two devices.
Further, in the corresponding electrode arrangement, the electrodes which are not connected to the through-hole interconnection, if any, are excluded, and only the electrodes which are connected to the through-hole interconnection are considered.

When the arrangements of the electrodes of the devices mounted on both sides are the same as each other, all the through-hole interconnections are formed perpendicular to the main surface of the substrate, or when all the through-hole interconnections, though formed inclined, are formed in the same direction (in parallel), the electrodes on both devices can be connected to each other in one-to-one correspondence through the through-hole interconnections.
However, in the invention, the arrangements of the electrodes between both devices are different from each other.
For this reason, when all the through-hole interconnections are formed perpendicular to the main surface of the substrate, or are formed so as to be parallel to each other though formed inclined, the positions between the electrodes and the conduction portions of at least one device are not matched with each other, and thus a surface wiring is required.
In the invention, in order to eliminate the need for the surface wiring for the connection between the devices, the arrangement of the first conductive portion 214 (first opening 14) and the arrangement of the electrodes of the first device 1 on the first main surface 11 are matched with each other, and the arrangement of the second conductive portion 215 (second opening 15) and the arrangement of the electrodes of the second device 2 on the second main surface 12 are matched with each other.
Thereby, the devices 1 and 2 can be connected to each other without providing the surface wiring in the interposer substrate 19.

In the examples of FIGS. 1A to 3, 5A, and 5B, the electrode arrangement of both devices 1 and 2 is a peripheral arrangement in which the electrodes 3 and 4 are lined up in the margins of the devices 1 and 2.
Furthermore, the dimensions of both devices 1 and 2 (the length, the area and the like in the direction along the main surfaces 11 and 12 of the substrate 10) are different from each other.
The through-hole interconnection 16 of the interposer substrate 19 is formed from the electrode 3 of the device 1 having small dimensions toward the electrode 4 of the device 2 having large dimensions.
That is, the first conductive portion 214 is located at the central portion of the first main surface 11 of the substrate 10, the second conductive portion 215 is located close to the outer circumference of the second main surface 12 of the substrate 10, and the through-hole interconnection 16 extends substantially radially.

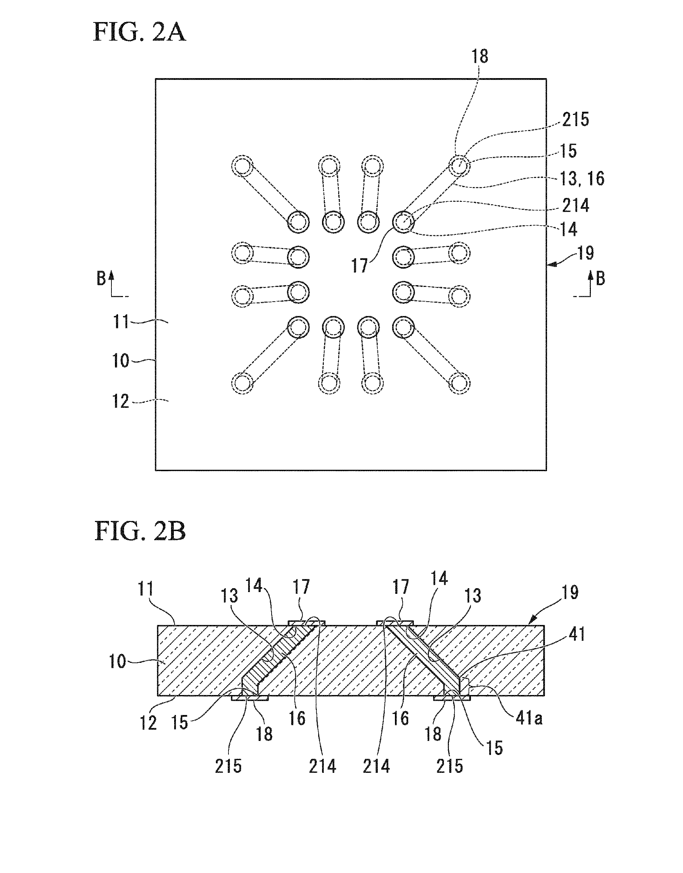

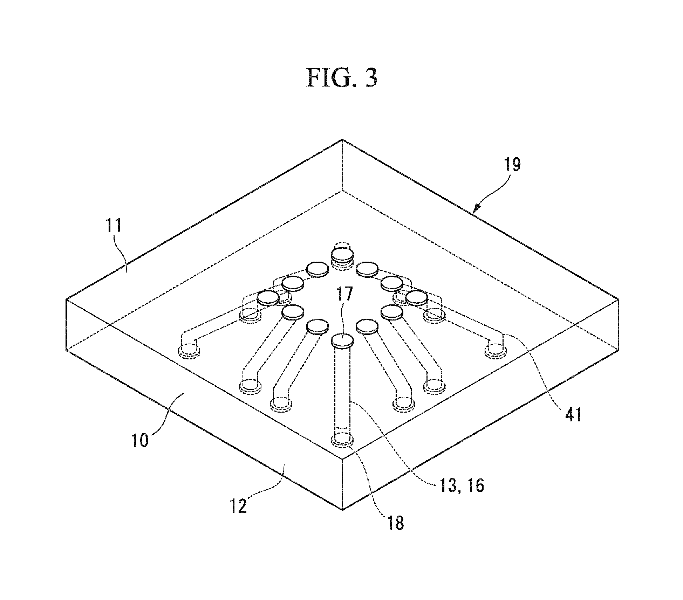

In this manner, in the interposer substrate 19 of the present embodiment, the through-holes 13 in which the through-hole interconnection 16 is provided are all nonparallel to each other (the linear portion 41 a and the linear portion 42a are excluded).
For this reason, in the method of forming the through-hole 13, a method capable of forming the through-hole 13 in an arbitrary direction can be adopted as described later.
Additionally, the direction of the through-hole 13 is not based on a plan view seen from the direction perpendicular to the main surfaces 11 and 12 of the substrate 10, but is perceived three-dimensionally including the thickness direction of the substrate 10.
For example, in FIG 2A, the through-holes 13 opposite to the center of the substrate 10 are the same as each other in terms of direction in a plan view. However, as shown in FIG 3, the directions from the first main surface 11 side toward the second main surface 12 side are different from each other three-dimensionally, and are nonparallel to each other.

The material of the substrate 10 includes an insulator such as glass, plastic, and ceramics, or a semiconductor such as silicon (Si).
In the case of the semiconductor substrate, it is preferable to form an insulating layer on the inner wall of the through-hole 13, the main surfaces 11 and 12, or the like.
In the case of the insulating substrate, it is not necessary to further form an insulating layer on the inner wall of the through-hole 13.
Meanwhile, when the difference of coefficient of thermal expansion (CTE) between the base material of the electronic device and the substrate in which an electronic device is mounted is large, the extension amounts of the two are considerably different from each other depending on the temperature at the time of the mounting, and thus misalignment between an electrode of the electronic device and a conductive portion on the substrate to which the electrode is connected easily occurs.
As a result, the high-accuracy connection between the two may be difficult to make, or the connection itself between the two may be difficult to make.
On the other hand, according to the invention, it is possible to use silicon or glass as the material of the substrate 10.
Therefore, for example, when the electronic devices 1 and 2 making use of a silicon base material are mounted on both main surfaces of the substrate 10, it is possible to reduce the above-mentioned difference of CTE.
As a result, misalignment between the electrodes of the electronic devices 1 and 2 and the conduction portion on the substrate 10 is suppressed, thereby allowing the two to be connected to each other with a high accuracy of the position.

As described above, the through-hole interconnection 16 is provided in the through-hole 13 including the first opening 14, formed in a position facing the electrode 3 of the first device 1, on the first main surface 11 of the substrate 10, and the second opening 15, formed in a position facing the electrode 4 of the second device 2, on the second main surface 12 of the substrate 10, by filling or forming the conductor therein.

In the formation of the through-hole 13, it is possible to use a method, employing both modification through a femtosecond laser and wet etching, which is a method particularly suitable for a substrate made of silica glass, or a method further employing a mechanical method such as an NC drill.
When the modification is performed using a femtosecond laser, the substrate material on the portion which is irradiated with a laser changes, and the resistance to an etchant is lower than that of the portion which is not irradiated with a laser. Therefore, a hole can be easily formed.

The conductor used in the through-hole interconnection 16 includes a metal such as copper (Cu) or tungsten (W), an alloy such as gold-tin (Au-Sn), or a nonmetallic conductor such as polysilicon.
As the manufacturing method, a plating method, a sputtering method, a molten metal filling method, CVD, a supercritical deposition method, or a combination thereof, and the like can be appropriately used.
Additionally, in the through-hole interconnection 16, it is preferable that the conductor is completely filled in the inside of the through-hole 13.

In the device packaging structure of the invention, the electrodes 3 and 4 of the device are respectively arranged so as to face the openings 14 and 15 of the through-hole 13 serving as the through-hole interconnection 16.
For this reason, when the through-hole interconnection 16 is a solid structure in which the conductor is completely filled in the inside of the through-hole 13, this is preferable because the stability of the mechanical and electrical connection increases as compared to a hollow structure in which the conductor layer is formed only in the inner wall of the through-hole 13.
At this time, as a method of completely filling the conductor in the inside of the through-hole, any one of methods of the above-mentioned plating method, sputtering method, molten metal filling method, CVD, supercritical fluid deposition method, and the like can be adopted.
Alternatively, these methods may be appropriately combined.
Particularly, when the length of the hole is long and the shape is complicated, a conductor thin film may be formed by the method capable of forming a film up to the deep portion of the hole such as the CVD and the supercritical fluid deposition method.
It is possible to completely fill the conductor in the inside of the through-hole more effectively by the continuous plating method or the molten metal filling method, using the conductor thin film as a seed layer or an adhesion layer.

The devices 1 and 2 include an integrated circuit (IC) such as a memory (storage device) and a logic (logic device), a MEMS device such as a sensor, and an optical device such as a light-emitting device and a light receiving element.
When the devices 1 and 2 have different electrode arrangements, the devices may have different functions, and may have the same function.
Particularly, integrating a heterogeneous device in a high density allows a three-dimensional system-in-package (SiP) to be realized.
In the case of the present embodiment, as shown in FIG 1B, a plurality of devices 1 are laminated on the substrate 10 at the first main surface 11 side.
In this manner, according to the present embodiment, it is possible to realize further densification.

In the manufacturing of the interposer substrate 19, the modified region 43 serving as the through-hole 13 having the openings 14 and 15 corresponding to the electrode arrangement of each of the devices 1 and 2 is formed in the substrate 10 (step A1), the through-hole 13 is formed by removing the modified region 43 from the substrate 10 (step A2), the through-hole interconnection 16 including the first conductive portion 214 exposed to the first main surface 11 side and the second conductive portion 215 exposed to the second main surface 12 side is formed by filling or forming the conductor in the through-hole 13 (step A3), and the electrode 3 is bonded to the corresponding first conductive portion 214 by disposing the first device 1 so as to face the first main surface 11 of the substrate 10, and the electrode 4 is bonded to the corresponding second conductive portion 215 by disposing the second device 2 so as to face the second main surface 12 of the substrate 10, to mount both devices 1 and 2 on both sides of the interposer substrate 19 (step A4).
Thereby, a plurality of electrodes 3 of the first device 1 and a plurality of electrodes 4 of the second device 2 are electrically connected to each other through a plurality of through-hole interconnections 16.

In the device packaging method of the invention, the above-mentioned step A1 includes a step of providing the linear portion 41 a and/or the linear portion 42a extending perpendicular to the same main surface of at least one of the first main surface 11 and the second main surface 12, in the modified region 43 serving as the each of the through-holes 13 constituting a plurality of through-hole interconnections 16, and a step of providing a portion which is connected to each of the linear portions and extends inclined to the first main surface 11 and the second main surface 12.
Here, the inclined extending portion is, for example, a portion from the bent portion 41 to the opening 14 in FIG 1B.
In another example, the inclined extending portion is a portion from the bent portion 41 to the bent portion 42 in FIG 5B.
The above-mentioned two steps may be discontinuously performed by the same method, and may be continuously performed by a different method.

For example, first, the linear portion and the inclined extending portion are modified in order using a laser technique or the like.
Subsequently, the inclined extending portion modified and the linear portion modified are removed in order using a wet etching method.
In this manner, these two steps may be continuously performed.
In addition, the linear portion is formed by a mechanical method such as an NC drill.
Thereafter, the inclined extending portion is formed by a laser technique and a wet etching method.
These two steps may be discontinuously performed.

In the device packaging method of the invention, as mentioned above with reference to FIGS. 4A to 4D, in the above-mentioned step A5, it is possible to reduce the thickness of the substrate by polishing the main surface on the side in which the linear portion is provided using physical or chemical means.
The physical means includes a method of performing mechanical polishing using a polishing solution including a polishing agency having a fine grain size.
In addition, the chemical means includes a method of performing etching using a solution or gas capable of corroding a substrate.

In the above-mentioned step A4 in the device packaging method of the invention, the electrode 3 of the first device 1 is bonded to the through-hole interconnection 16 by disposing the first device 1 on the first main surface 11 side of the substrate 10, and the electrode 4 of the second device 2 is bonded to the through-hole interconnection 16 by disposing the second device 2 on the second main surface 12 side of the substrate 10.
Thereby, a plurality of electrodes 3 of the first device 1 and a plurality of electrodes 4 of the second device 2 can be electrically connected to each other through a plurality of through-hole interconnections 16.
Other methods may be used insofar as such a connection can be made.
For example, in the case of the present embodiment, the electrodes 3 and 4 of each of the devices 1 and 2 and the through-hole interconnection 16 are connected to each other by conductive land portions 17 and 18 provided in the openings 14 and 15 of the through-hole 13, and bonding materials 5 and 6 which are conductors (solders, conductive bumps or the like) provided on the land portions 17 and 18.
In the invention, the land portions 17 and 18 or the bonding materials 5 and 6 may be omitted.
For example, the electrodes 3 and 4 and the through-hole interconnection 16 may be bonded to each other directly by a solder or the like.

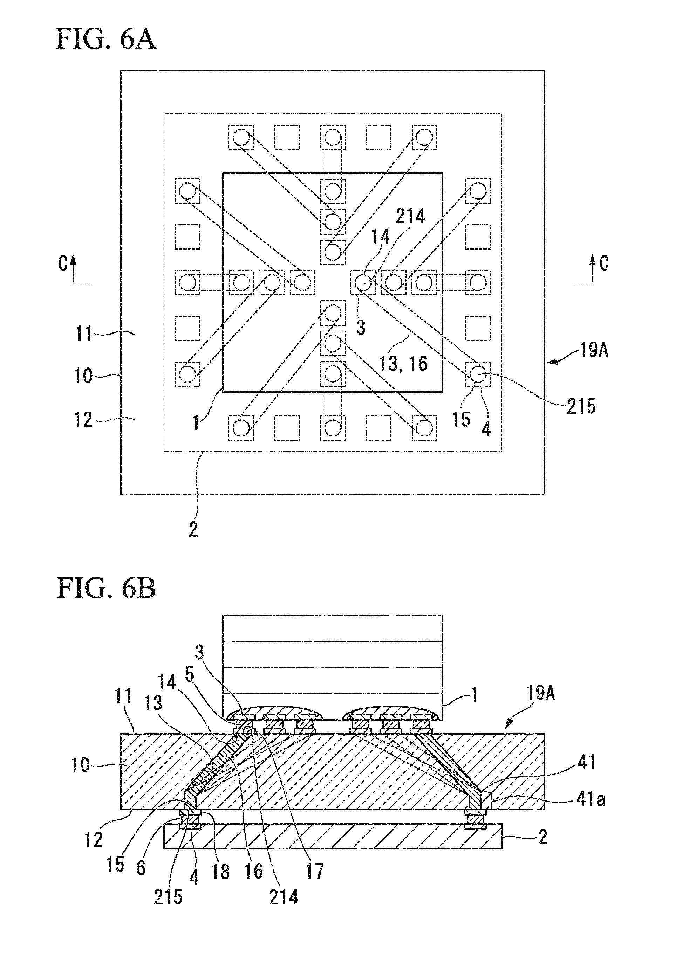

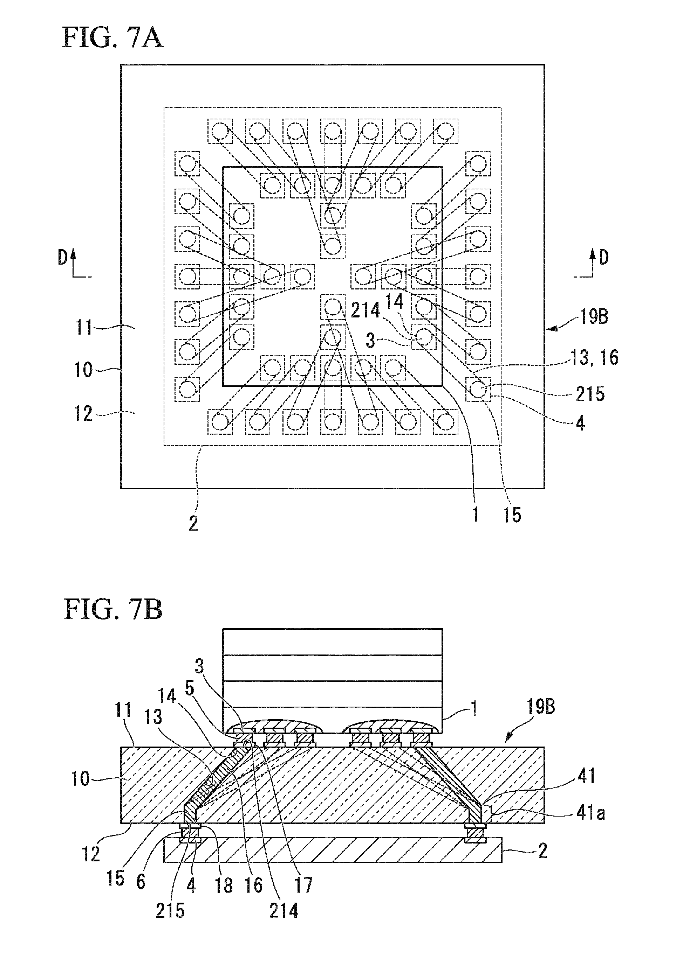

In the device packaging structure shown in FIGS. 1A to 3, the electrode arrangement of the devices 1 and 2 is a peripheral arrangement in which the electrodes 3 and 4 are lined up in the margins of the devices 1 and 2.
In addition, in the device packaging structure according to a second modified example of the present embodiment shown in FIGS. 6A and 6B, the electrode arrangement of the first device 1 is an arrangement in which the electrodes 3 are lined up in a cross shape, and the electrode arrangement of the second device 2 is a peripheral arrangement in which the electrodes 4 are lined up in the margin of the device 2.
In addition, in the device packaging structure according to a third modified example of the present embodiment shown in FIGS. 7A and 7B, the electrode arrangement of the first device 1 is a lattice-type arrangement in which the electrodes 3 are lined up in the peripheral portion in a cross shape, and the electrode arrangement of the second device 2 is a peripheral arrangement in which the electrodes 4 are lined up in the margin of the device 2.

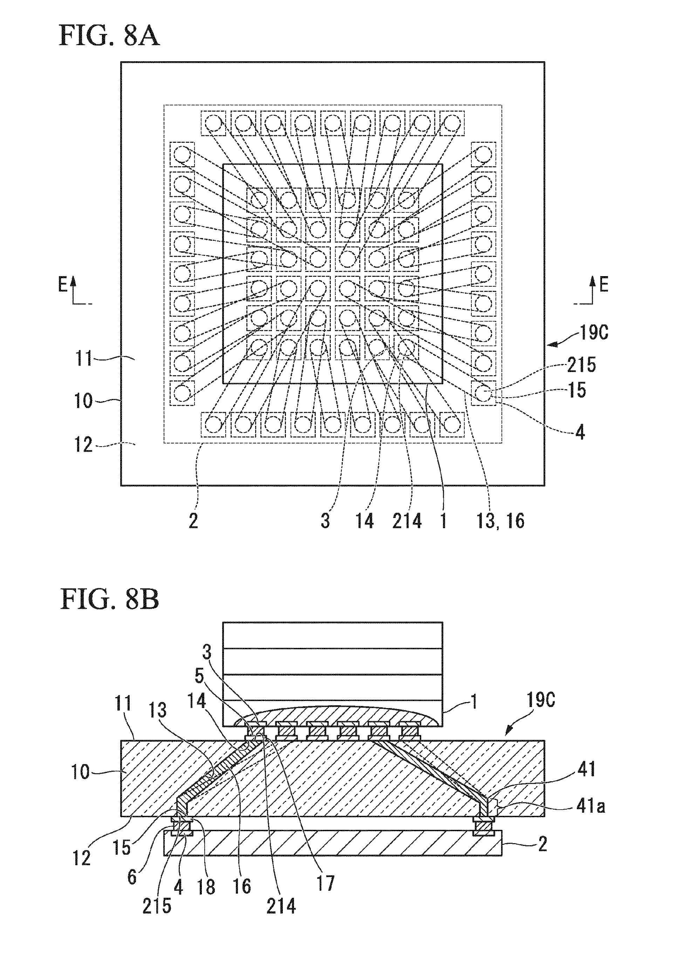

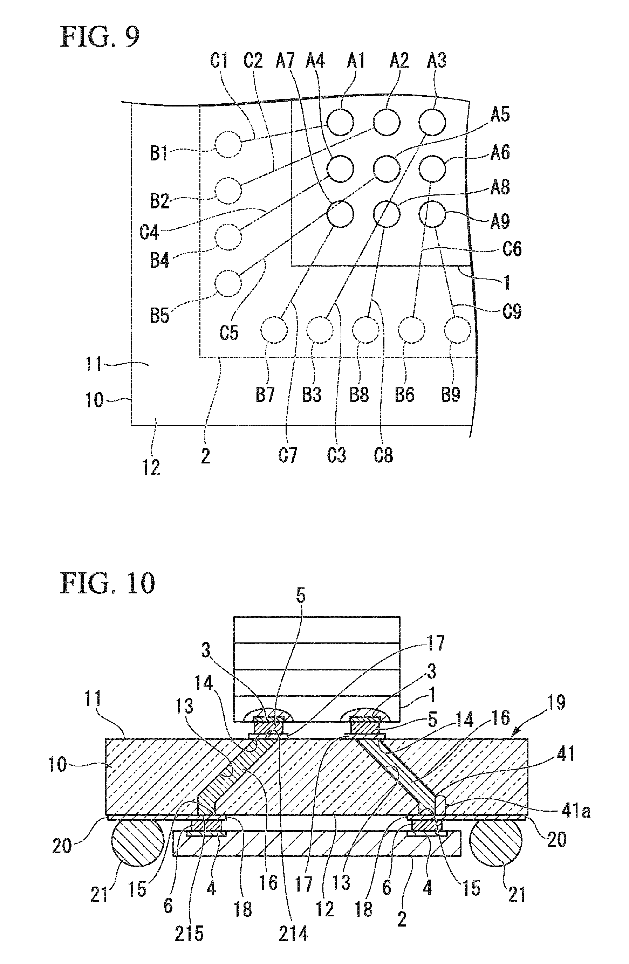

In addition, in the device packaging structure according to a fourth modified example of the present embodiment shown in FIGS. 8A and 8B, the electrode arrangement of the first device 1 is an area-array arrangement in which the electrodes 3 are lined up lengthwise and breadthwise, and the electrode arrangement of the second device 2 is a peripheral arrangement in which the electrodes 4 are lined up in the margin of the device 2.
Additionally, FIG 9 schematically illustrates a connection relationship of the electrodes in the lower-left quarter portion of the device packaging structure shown in FIGS. 8A and 8B.
Here, signs A1 to A9 denote the land portions 17 on the first main surface 11 connected to the electrodes 3 of the first device 1.
In addition, signs B1 to B9 denote the land portions 18 on the second main surface 12 connected to the electrodes 4 of the second device 2.
In addition, signs C1 to C9 denote the through-hole interconnections 16 for connecting A1 to A9 and B1 to B9, respectively.
In addition, the invention is not limited to the above-mentioned illustrations, but other electrode arrangements may be combined.

In the examples shown in FIGS. 1A to 3 and FIGS. 5A to 9, for the purpose of description, the dimensions of the second device 2 in a plan view is larger than the first device 1.
In addition, the electrodes 4 of the second device 2 are peripherally arranged.
However, in the invention, as in the above-mentioned examples, the electrodes 4 of the second device 2 may be arranged at positions overlapping the first device 1 in a plan view with respect to the substrate 10.
In addition, the dimensions of the first device 1 in a plan view may be the same as those of the second device 2.
In this manner, even when the electrodes 3 and 4 of both devices 1 and 2 have any of the electrode arrangements (layouts) on each of the devices 1 and 2, the electrodes 3 and 4 can be connected to each other at a substantially shortest distance, which effects faster connection of the device.
In addition, the pitch between the interconnections can be converted in the insides of the interposer substrates 19, 19', 19A, 19B, and 19C without being multilayered as in a build-up substrate. Therefore, the electrodes 3 and 4 of both devices 1 and 2 can be efficiently connected to each other.

In the device packaging structure of the invention, as shown in FIG 10, bumps 21 made of a solder or the like can be provided.
In the example shown in FIG 10, the interposer substrate 19 includes connection terminals 21 such as a solder bump in the second main surface 12 side of the substrate 10.
The devices 1 and 2 and an external substrate (not shown) such as a printed circuit board can be electrically connected to each other through the through-hole interconnection 16 or a circuit 20.
In addition, the device 1 is laminated on the first main surface 11 side.

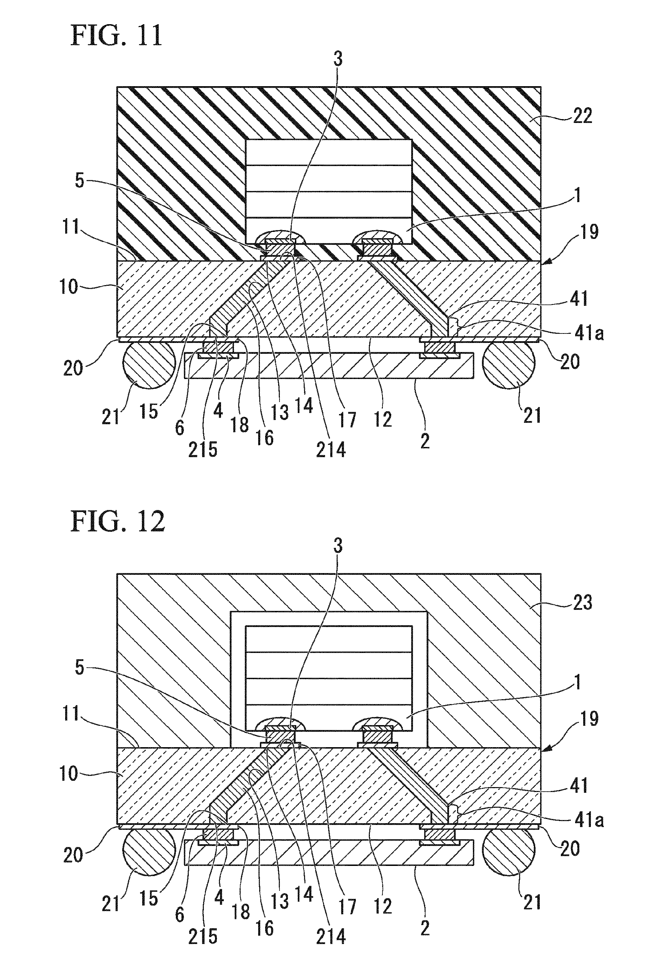

In addition, in the device packaging structure of the invention, the device 1 can be coated by a molding resin layer 22 as shown in FIG 11, or the device 1 can be covered by a protective member 23 by a cavity as shown in FIG 12.
Thereby, the device 1 can be protected.

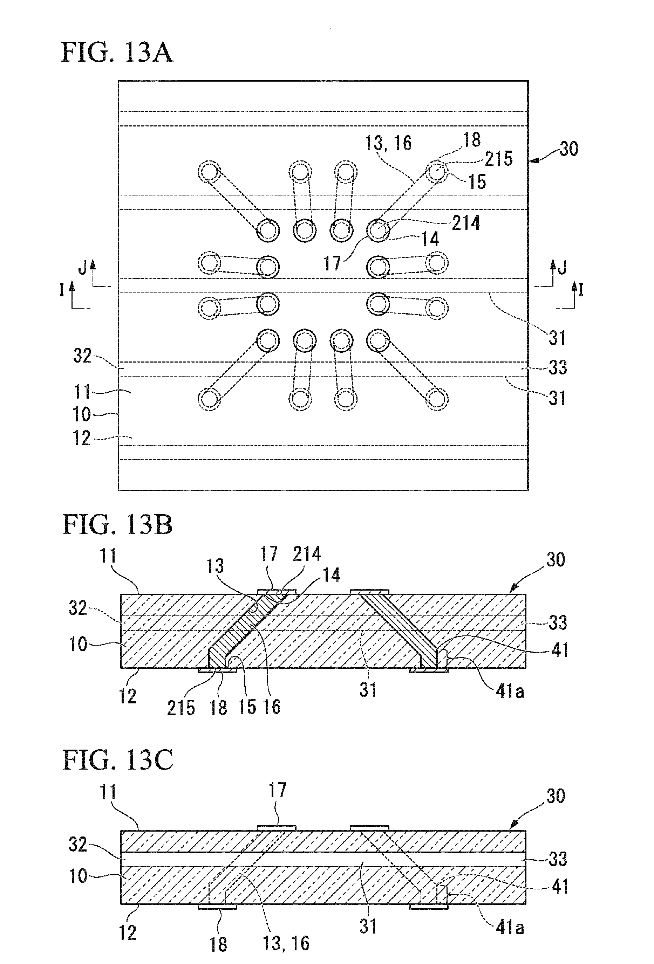

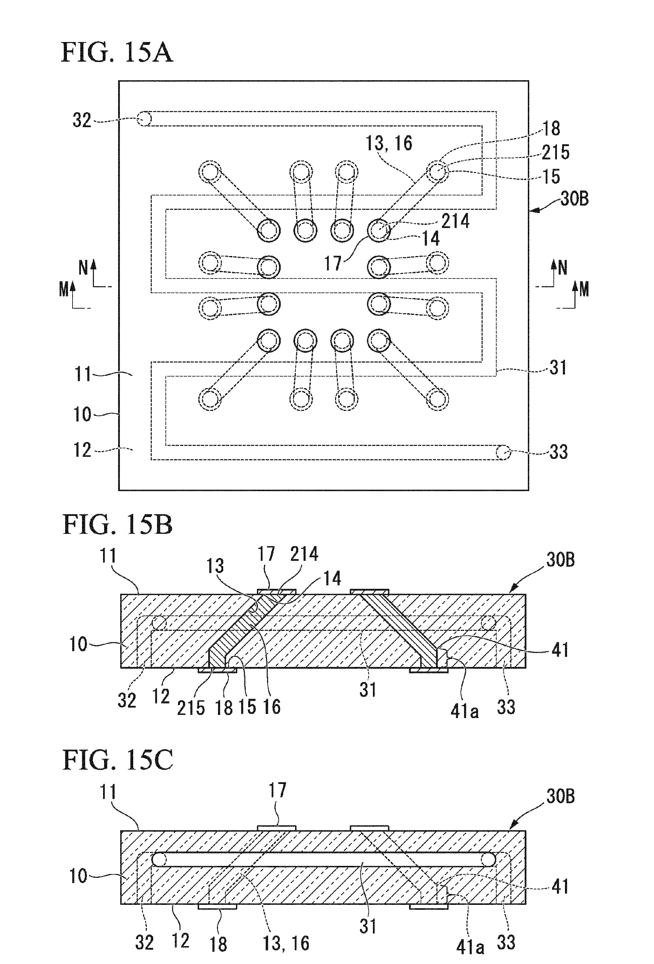

In addition, in the device packaging structure of the invention, as shown in FIGS. 13A to 15C, a flow channel 31 can be provided in the inside of the substrate 10.
The flow channel 31 is used as a flow channel that circulates, for example, a cooling fluid such as water.
Furthermore, the flow channel 31 can be used as a flow channel that circulates a biological solution such as DNA (nucleic acid), protein, and lipid.
When the flow channel 31 is used as a flow channel that circulates a cooling fluid, the first device is packaged on the first main surface 11 side of interposer substrates 30, 30A, and 30B with a flow channel shown in FIGS. 13A to 15C, and the second device is packaged on the second main surface 12 side. Therefore, the interposer substrates 30, 30A, and 30B with a flow channel can be cooled.
Thereby, even when the electrodes of the first device and/or the second device are densely arranged, it is possible to effectively reduce a rise in temperature of the interposer substrates 30, 30A, and 30B with a flow channel.
Hereinafter, a case where the flow channel 31 is used as a flow channel that circulates a cooling fluid will be described.

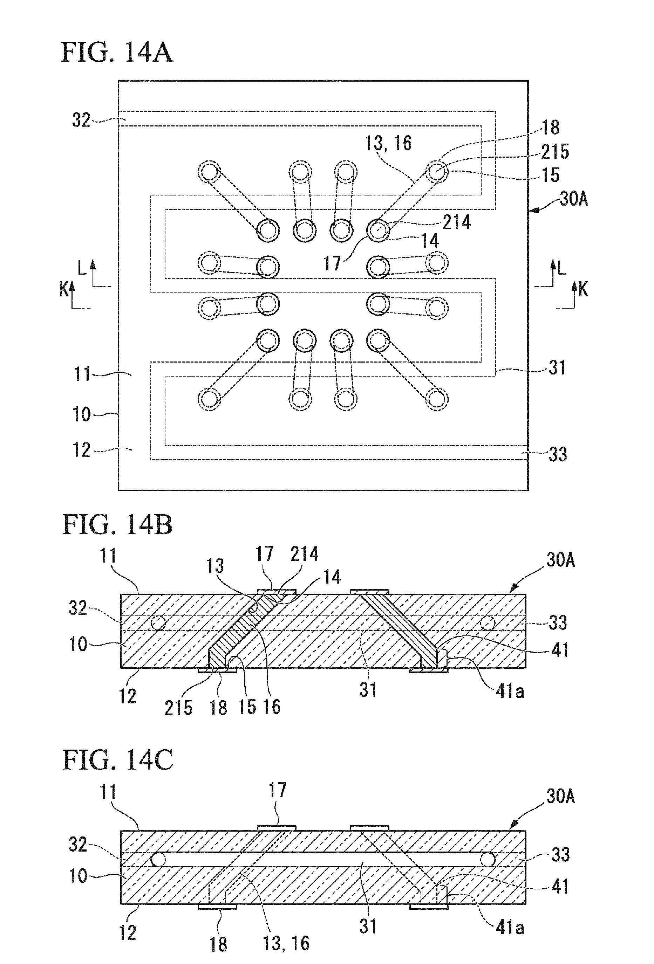

The flow channel 31 includes inlet and outlet ports 32 and 33, for taking a cooling fluid in and out, on both ends thereof.
For example, as shown in FIGS. 13A to 13C, a plurality of flow channels 31 may be provided.
In addition, as shown in FIG 14A, one flow channel 31 may be meanderingly provided so as to cool the entirety of the substrate 10.
In addition, as shown in FIGS. 15A to 15C, the inlet and outlet ports 32 and 33 of the flow channel 31 may be opened in the main surface 12 of the substrate 10.
In addition, the pattern (path) or the cross-sectional shape of the flow channel 31 is not limited to only the illustrations mentioned above, but can be appropriately designed.

The flow channel 31 is preferably spaced at a predetermined interval from the through-hole 13 three-dimensionally in the surface direction or the thickness direction so as not to communicate with the through-hole 13 having the through-hole interconnection 16.
In the present embodiment, as shown in FIG 13A and the like, even when the flow channel 31 parallel to the main surfaces 11 and 12 of the substrate 10 is likely to overlap the through-hole 13 in a plan view, the through-hole 13 and the flow channel 31 do not communicate with each other.
That is, when the positions in the thickness direction of the substrate 10 are misaligned with each other, the through-hole 13 and the flow channel 31 are not connected to each other.

In addition, in the invention, since it is assumed that the thickness of the substrate 10 may fluctuate, it is preferable that the through-hole used as the flow channel 31 is more distant than the lengths of the linear portion 42a and the linear portion 41 a from the main surface 11 and 12, and is formed in the central portion of the thickness of the substrate 10.

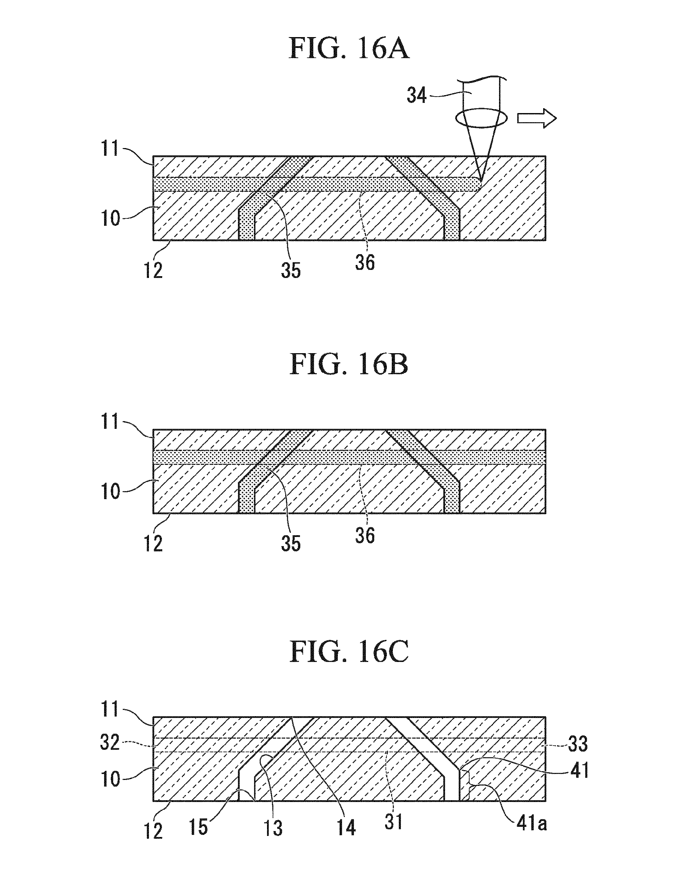

The flow channel 31 is formed in step A5 of forming a through-hole used as the flow channel 31 of a cooling fluid, in addition to the through-hole 13 in which the through-hole interconnection 16 is formed.
Here, when the above-mentioned step A5 is performed in parallel with the above-mentioned steps A1 and A2, it is possible to raise the manufacturing efficiency of the interposer substrate.
An example of the method of manufacturing the interposer substrate 30 in this case is shown in FIGS. 16A to 16F.

First, as shown in FIGS. 16A and 16B, the substrate 10 is irradiated with laser light 34 to form modified regions 35 and 36 of which the material of the substrate 10 is modified within the substrate 10.
The modified region 35 is provided in a region in which the through-hole 13 is formed, and the modified region 36 is provided in a region in which the through-hole used as the flow channel 31 is formed.

In the present embodiment, using a femtosecond laser as a light source of the laser light 34, laser beam irradiation is performed so as to be focused within the substrate 10, and the modified regions 35 and 36 having a diameter of, for example, several µm to several tens of µm are obtained.
The focal point of the laser light 34 within the substrate 10 is controlled, thereby allowing the modified regions 35 and 36 having a desired shape to be formed.
In addition, the modified regions 35 and 36 generally have a further change in the refractive index than the material of the substrate 10.

As shown in FIGS. 16A to 16F, the modified region 36 serving as the flow channel 31 may be formed in parallel to the main surfaces 11 and 12 of the substrate 10.
At this time, when the irradiation range (particularly, the range from the laser light source to the focal point within the substrate 10) of the laser light 34 overlaps the modified region 35 serving as the through-hole 13, there may be a concern that the focal point of the laser light 34 is misaligned in the range in which the laser light 34 and the modified region 35 overlap each other due to a change in the refractive index of the modified region 35.
In this manner, in order to avoid overlapping the other modified region 35 which is already formed, the substrate may not only be irradiated from the first main surface 11 side with the laser light 34, but also be irradiated from the second main surface 12 side with the laser light 34 in some places.

Subsequently, the substrate 10 in which the modified regions 35 and 36 are formed is immersed in an etching solution (chemical), and the modified regions 35 and 36 are removed from the substrate 10 by etching (wet etching).
As a result, as shown in FIG 16C, a through-hole used as the through-hole 13 and the flow channel 31 is formed in a portion in which the modified regions 35 and 36 exist.
In the present embodiment, silica is used as a material of the substrate 10, and a hydrofluoric acid (HF)-based solution is used as an etching solution.
This etching is used in very rapidly etching the modified regions 35 and 36 compared to the portion in which the substrate 10 is not modified, and as a result, it is possible to form a through-hole used as the through-hole 13 and the flow channel 31 depending on the shapes of the modified regions 35 and 36.

In the present embodiment, the hole size of the through-hole 13 is set to 50 µm.
The hole size of the through-hole 13 can be appropriately set from approximately 10 µm to approximately 300 µm in accordance with the use of the through-hole interconnection 16.
The hole size of the through-hole used as the flow channel 31 may be approximately the same as, smaller (thinner) than, or larger (thicker) than the hole size of the through-hole 13.
The hole size of the through-hole used as the flow channel 31 is not particularly limited, but can be set to, for example, approximately 10 µm to approximately 500 µm.
In addition, the hole size of the through-hole used as the flow channel 31 may have a partially thin portion or partially thick portion.

Additionally, the etching solution is not limited to a hydrofluoric acid, but, for example, a hydrofluoric nitric acid-based mixed acid obtained by adding a hydrofluoric acid to an appropriate amount of nitric acid or the like or an alkaline aqueous solution such as potassium hydroxide can also be used as the etching solution.
In addition, other chemicals can also be used in accordance with the material of the substrate 10.

The material of the substrate 10 is not limited to silica glass (silica glass), but, for example, an insulating substrate such as a sapphire or a glass substrate containing other components such as an alkaline component can be used as the material thereof, and the thickness thereof can be appropriately set to approximately 150 µm to 1mm.

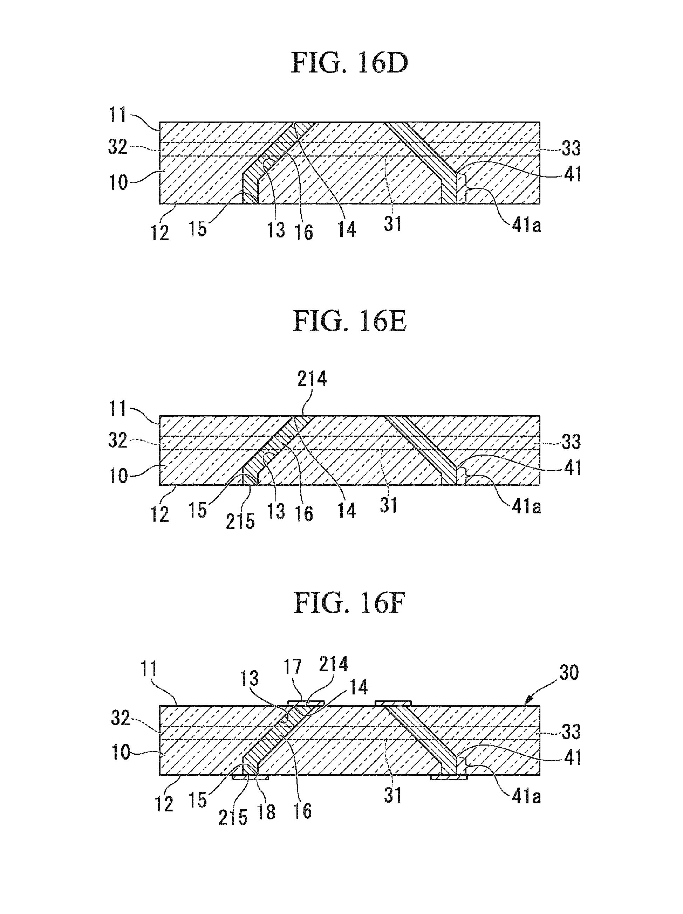

Next, as shown in FIG 16D, the through-hole interconnection 16 is formed by filling or forming a conductor in the through-hole 13.
A plating method, a sputtering method, a molten metal filling method, CVD, a supercritical fluid deposition method, or the like can be appropriately used in filling or forming the conductor.
At this time, a protective layer such as a resist is preferably provided in advanced in the positions of the inlet and outlet ports 32 and 33 of the flow channel 31 so that the conductor is not infiltrated into the through-hole used as the flow channel 31.
As the resist, a resin resist, a thin film of an inorganic material or the like can be used.

Thereafter, the substrate 10 is polished from the second main surface 12 side on which the linear portion 41 a is formed by a mechanical polishing method or the like, and the substrate 10 is formed to a desired thickness (FIG 16E).
Further, as shown in FIG 16F, the land portions 17 and 18 are formed over and under the through-hole interconnection 16 as necessary.
As a method of forming the land portions 17 and 18, a plating method, a sputtering method or the like can be appropriately used.

In this manner, when the through-hole 13 and the flow channel 31 are simultaneously formed, it is possible to simplify the manufacturing process, and to reduce the costs.
In addition, since the positional relationship between the through-hole 13 and the flow channel 31 is easily controlled, it is possible to prevent the through-hole 13 and the flow channel 31 from being incorrectly connected to each other.
Additionally, after a plurality of modified regions 35 and 36 are formed, it is not necessary to form a through-hole used as the through-hole 13 or the flow channel 31 by etching all the modified regions 35 and 36.
For example, a portion of the modified regions 35 and 36 is protected so as not to be etched by providing a protective layer such as a resist on both ends thereof, thereby allowing the etched modified regions 35 and 36 to be selected.
Thereby, a through-hole used as the through-hole 13 or the flow channel 31 can be formed only in a required position.
For example, when the modified region 35 is previously formed so as to correspond to all the electrodes 3 and 4 of the devices 1 and 2, and then it is not necessary to provide the through-hole interconnection 16 with respect to a portion of the electrodes 3 and 4 depending on the use aspect or the like of the devices 1 and 2, the modified region 35 corresponding to a place in which the through-hole interconnection 16 is not required is protected so as not to be etched, thereby allowing the through-hole 13 to not be opened.
In this manner, since the modified region 35 is uniformly formed in a step of forming the modified region 35, and then the position in which the through-hole interconnection 16 is formed can be selected in an etching step, the irradiation position of laser light in which the modified region 35 is formed is easily controlled.

In addition, in the above-mentioned step of forming the through-hole (fine hole)13 3 and/or the flow channel 31, the method of forming the modified regions 35 and 36 having a desired shape within the substrate 10 by controlling the focal point of the laser light from a femtosecond laser is described, but the invention is not limited thereto.
For example, a hologram in which a pattern corresponding to the desired shape of the modified regions 35 and 36 is recorded is arranged between the femtosecond laser and the substrate, and the substrate is irradiated with the laser light through the hologram, thereby allowing modified regions having a desired shape to be collectively formed in the inside of the substrate.
Thereafter, it is possible to form desired through-holes (fine holes) and/or flow channels by etching the modified regions.

### INDUSTRIAL APPLICABILITY

The invention can be widely used in mounting devices on both sides of a substrate using an interposer substrate having a through-hole interconnection passing through the substrate.

### DESCRIPTION OF THE REFERENCE SYMBOLS

1: first device
2: second device
3, 4: electrode
10: substrate
11: first main surface (one main surface)
12: second main surface (the other main surface)
13: through-hole
14: first opening
15: second opening
16: through-hole interconnection
19, 19', 19A, 19B, 19C: interposer substrate
30, 30A, 30B: interposer substrate with a flow channel
31: flow channel
35, 36: modified region
41, 42: bent portion
41 a, 42a: linear portion
43, 46: modified region

## Claims

1. A device mounting structure comprising:
an interposer substrate comprising a substrate and a plurality of through-hole interconnections formed inside a plurality of through-holes passing through the substrate from a first main surface toward a second main surface, the first main surface being one main surface of the substrate, the second main surface being the other main surface thereof;
a first device which includes a plurality of electrodes and is arranged so that these electrodes face the first main surface; and
a second device comprising a plurality of electrodes of which an arrangement is different from an arrangement of each of the electrodes of the first device, and is arranged so that these electrodes face the second main surface, wherein
each of the through-hole interconnections comprises a first conductive portion which is provided at a position corresponding to the electrode of the first device, on the first main surface, and a second conductive portion which is provided at a position corresponding to the electrode of the second device on the second main surface,
each of the electrodes of the first device is electrically connected to the first conductive portion,
each of the electrodes of the second device is electrically connected to the second conductive portion, and
each of the through-hole interconnections comprises a linear portion vertically extending from at least one of the first main surface and the second main surface.

2. The device packaging structure according to claim 1, wherein
a flow channel is provided inside the substrate.

3. A device mounting method of electrically connecting a first device comprising a plurality of electrodes to a second device comprising a plurality of electrodes of which an arrangement is different from an arrangement of each of the electrodes of the first device, through an interposer substrate comprising a substrate, and a plurality of through-hole interconnections formed inside a plurality of through-holes passing through the substrate from a first main surface which is one main surface of the substrate toward a second main surface which is the other main surface thereof, the method comprising:
step A1 of forming a plurality of modified regions which comprise one end which is exposed to a position corresponding to each of the electrodes of the first device, on the first main surface, and the other end which is exposed to a position corresponding to each of the electrode of the second device, on the second main surface;
step A2 of forming the plurality of through-holes in a region in which the plurality of modified regions are formed;
step A3 of forming a plurality of through-hole interconnections comprising a first conductive portion exposed to the first main surface side and a second conductive portion exposed to the second main surface side, by filling or forming a conductor within each of the through-holes; and
step A4 of bonding each of the electrodes of the first device to the corresponding first conductive portion by disposing the first device so as to face the first main surface of the substrate, and bonding each of the electrodes of the second device to the corresponding second conductive portion by disposing the second device so as to face the second main surface of the substrate, wherein
the step A1 comprises a step of providing a linear portion vertically extending from at least one of the first main surface and the second main surface, and a step of providing a portion which is connected to the linear portion and extends inclined to both the first main surface and the second main surface.

4. The device packaging method according to claim 3, further comprising:
a step of reducing a thickness of the substrate by polishing a main surface in which the linear portion is provided using physical or chemical means.

5. The device packaging method according to claim 3 or 4, further comprising:
step A5 of forming a flow channel inside the substrate.
